# EUROPEAN PATENT SPECIFICATION

(11) **EP 3 056 912 B1**
(45) Date of publication and mention of the grant of the patent: **07.04.2021**
(21) Application number: 15203192.8
(22) Date of filing: 30.12.2015
(51) Int. Cl.: H01R 101/00, G01R 1/067, G01R 1/073, H01R 13/24

(54) **HIGH FREQUENCY PROBE TIP**
HOCHFREQUENZ SONDENSPITZE
POINTE DE SONDE POUR HAUTES FREQUENCES

(30) Priority: 31.12.2014 US 201414587703
(43) Date of publication of application: 17.08.2016
(73) Proprietor: Tektronix, Inc., Beaverton, Oregon 97077-0001 (US)
(72) Inventor: CAMPBELL, Julie, Beaverton, OR 97008 (US); POLLOCK, Ira, Hillsboro, OR 97123 (US); HAGERUP, William, Portland, OR 97229 (US); ENNS, Christina, Beaverton, OR 97005 (US)
(74) Representative: HGF

(56) References cited:
- DE-A1- 3 533 227
- DE-A1-102009 008 156
- DE-U1- 8 417 746
- US-A- 2 849 681
- US-A1- 2003 222 665
- US-A1- 2005 079 772
- US-B1- 7 116 121
- Jis-c: "Carbon Film MELF Resistors", , 1 June 2011 (2011-06-01), pages 1-2, XP055277810, Retrieved from the Internet: URL:http://www.cinetech.com.tw/upload/2011 /06/20110617152049.pdf [retrieved on 2016-06-03]
- Henry W. Ott: "Balanced Differential Probe" In: "Electromagnetic Compatalibitity Engineering", 18 August 2009 (2009-08-18), Wiley, Hoboken, NJ, XP055462902, ISBN: 978-0-470-18930-6 pages 698-700,

## Description

### Technical Field

This disclosure relates generally to test probes and, more particularly, to probe tips for test probes.

### Background

Today's engineers are attempting to test devices that carry high-speed serial busses. Many of these devices can be identified as, but are not limited to, double data rate second generation (DDR2) synchronous dynamic random-access memory (SDRAM), double data rate fourth generation (DDR4) SDRAM, and peripheral component interconnect express (PCIe). The magnitude of voltage swings and pulse frequencies are very high and the complexity of the signaling requires precise electrical probing. These and other busses are becoming highly prevalent in various types of consumer hardware devices. There are many test points of interest in each of these products.

The test points in these products vary greatly in both geometry and accessibility, usually requiring one or two points of contact. Typically, points of contact include micro traces, vias, component pads, and connector contacts that provide electrical contact with and, thus, access to high-speed signals. However, the test points are not always in the same plane and, if two probe contacts are required at once (e.g., as in the case of a differential probe), tip compliance is highly desirable to assist with positioning the probe for proper contact. Points of contact may reside on principal component analysis (PCA) hardware in virtually every angle of orientation, including from vertical to horizontal. In these types of scenarios, the test points are better accessed by probe tips with compliance.

While there are semi-permanent forms of probe contact for these access points, including the soldering or conductive epoxying of wires to these points, such solutions present a number of disadvantages, including potential damage to the device under test (DUT) during connection, long set-up times, and a requirement for exceptional dexterity skills in order to solder wires to these test points. Also, semi-permanent contacts do not provide for quick debugging. Solder-in probe tips tend to wear out after only a few connections and, thus, create a need for replacements, which can be significantly expensive. Finally, there tends to be a high variability in the signal fidelity, particularly in upper signal frequencies, due to the quality and geometry of solder and/or epoxy connections.

Accordingly, there remains a need for improved probe tips for use in connection with test probes.

US7116121 B1 discloses avoiding uncontrolled characteristic impedance along a spring biased pin probe assembly, by providing a stepped shelf of ground plane that extends outward along the pin and toward the target signal. The length of outward extension is chosen such that even when there is only (or at least) an expected minimum amount of compression of the spring while producing and maintaining contact, the entire exposed portion of the pin is over the shelf, whose depth of step has been selected to produce a selected Z0 for the exposed pin that matches Z0 for existing transmission lines already within the probe assembly. The spring biased pin may be a resistor tip spring pin that includes a small resistor in its tip.

DE3533227 A1 discloses a spring contact pin for test devices, for testing electrical items under test. Said spring contact pin has a cylindrical element in whose cylinder the piston of a spring-loaded contact bolt is supported such that it can slide. A coating is provided at the transition from the piston to the piston track of the cylinder and consists of an inner layer, which acts as a diffusion barrier and exhibits nickel, and of an outer layer, which is applied on this inner layer and exhibits noble metal. In order to achieve a particularly low electrical contact resistance, the thickness of the outer layer of the coating on the circumference of the piston and/or on the piston track of the cylinder is less than 2 mu m.

DE8417746 U1 discloses a contact element for the electrical testing of printed circuit boards or the like, the contact element comprising or forming a metallic contact pin for contacting test points of the printed circuit boards or the like, characterized in that a metallic crown is provided on the front end region of the contact pin and which is used for the purpose of contacting with test points of printed circuit boards or the like.

US2003/222665 A1 discloses a resistive pin for use in a voltage probe including a pin-head that is configured to contact a test point in a device under test, and a resistor that is attached to the pinhead. Other systems are also provided for establishing electrical connections between testing instruments and devices under test.

US2849681 A discloses an electrical probe comprising a fixed tip and an insulation handle having a back contact therein, a conductor leading to said handle and connected to said back contact, a resistor connected in series between said tip and said back contact, a slidable sleeve made of insulation and surrounding said resistor, and a contact spring secured, inside of and extending longitudinally of said sleeve, said spring being so shaped that it exerts its resilient contact pressure radially of the sleeve, said spring being slidable axially with said sleeve between one position in which the spring connects the tip and the back contact and thereby short circuits the resistor, and another position in which the spring does not connect the tip and the back contact and thus leaves the resistor in series.

DE102009008156 A1 discloses a probe having a probe tip projecting from front surfaces of the tip, and an internal conductor axially shifted against the force of a spring element. The internal conductor is elastically supported in the spring element. Outer and inner piston sections are aligned coaxial to each other and provides a section of the internal conductor. The piston sections are electrically connected with a separate ohmic resistance body. The resistance body is axially arranged between the piston sections.

US2005/079772 A1 discloses an electrical connector having a body with a number of probes. Each probe has a spring biased pin with a contact tip, and includes a sleeve receiving the pin. Each sleeve has a first end connected to an incoming conductor, a second end connected to the body and from which the pin protrudes, and an intermediate portion suspended out of contact with the body. The sleeve may be spaced apart from adjacent sleeves, and suspended in air except at their ends. The probes may each be connected to coaxial cables, with alternating probes connected in alternating fashion to coaxial cable shields and signal conductors.

### Summary

The present invention provides a differential probe according to claim 1. Embodiments of the disclosed technology generally pertain to probe tips suitable for use with test probes. A test probe tip may include a compliance member or force deflecting assembly that includes a barrel component that receives a plunger base coupled with a resistive/impedance element that is also coupled with a tip component. A spring mechanism may be trapped or otherwise positioned within the barrel component and the plunger base may be configured to slide axially inside the barrel component and be acted upon by the spring mechanism therein to advantageously create a compression resistance, e.g., with a test point on a DUT.

### Brief Description of the Drawings

FIGURE 1 illustrates an exploded view of an example of a probe tip in accordance with certain embodiments of the disclosed technology.
FIGURE 2 illustrates an assembled view of the probe tip illustrated by FIGURE 1 in accordance with certain embodiments of the disclosed technology.
FIGURE 3 illustrates an example of a single-tip test probe in accordance with certain embodiments of the disclosed technology.
FIGURE 4 illustrates an example of a differential probe in accordance with certain embodiments of the disclosed technology.
FIGURE 5 is a graphical representation of an example of a frequency response plot for a test probe tip in accordance with certain embodiments of the disclosed technology.

### Detailed Description

Embodiments of the disclosed technology generally include probe tips suitable for use with a test probe and configured to provide a precise, height-compliant, quick, and light-pressure contact with a test point, e.g., on a device under test (DUT). Such a probe tip may be configured as a spring probe that includes a resistive or impedance element positioned nearly at the point of contact with the DUT. The resistive or impedance element may greatly improve the through response of the spring probe and also decrease the DUT loading significantly, thus enabling high-speed signal acquisition.

Test probes and probe tips in accordance with the disclosed technology may advantageously create a better physical and electrical control of the contact area and also lend themselves well to fast debugging environments that typically cannot accommodate long contact setup times. Test probes and probe tips in accordance with the disclosed technology may advantageously provide superior visibility for connection placement and intuitive operation various classes of products, specifically hand-held or rapid placement probing.

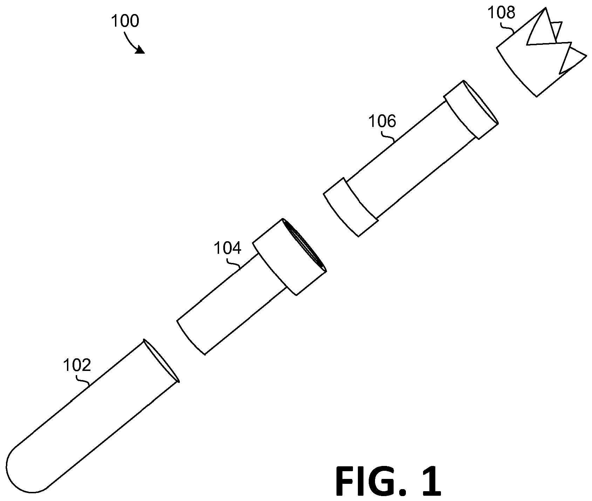

FIGURE 1 illustrates an exploded view of an example of a test probe tip 100 in accordance with certain embodiments of the disclosed technology. In the example, the test probe tip 100 includes a compliance member or force deflecting assembly and a tip component 108 coupled therewith.

In the example, the compliance member or force deflecting assembly includes a barrel component 102 configured to be integrated with a test probe. The probe tip 100 also includes a resistive/impedance element 106, e.g., a round rod resistor, and a plunger base component 104 configured to be coupled, e.g., by way of an electro-mechanical bond, with an end surface of the resistive/impedance element 106.

The resistive/impedance element 106 has a tube-like form with resistance on the outside full circumference thereof. The resistive/impedance element 106 includes a resistive coating that covers a tube and the metal connection is a short overlapping tube on the ends. The tube-like structure of the resistor may enable high bandwidth, low bandwidth loading. Round surfaces of the resistive/impedance element 106 may advantageously maximize the cross-sectional strength of the resistive/impedance element 106.

In the example, the tip component 108 is configured to be coupled by way of an electro-mechanical bond, with an end surface of the resistive/impedance element 106 opposite the end surface that is coupled with the plunger base component 104. The tip component 108 may have one or more sharp points, e.g., to establish or otherwise facilitate fine-grain electrical connectivity with one or more contact points on a DUT.

**A** spring mechanism may be trapped or otherwise positioned within the barrel component 102, and the plunger base 104 may be configured to slide axially inside the barrel component 102 and, consequently, be acted upon by the spring mechanism positioned inside the barrel component 102 to advantageously create a compression resistance.

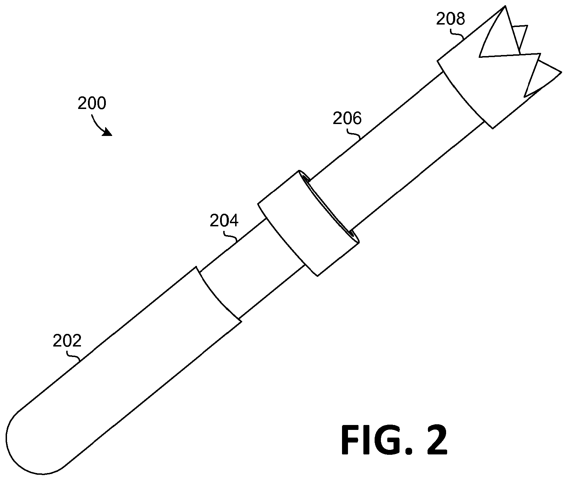

FIGURE 2 illustrates an assembled view of an example of a test probe tip 200 having a compliance member or force deflecting assembly and a tip component coupled therewith in accordance with certain embodiments of the disclosed technology. In the example, a barrel component 202 receives a plunger base 204 that is coupled, e.g., by way of an electro-mechanical bond, with an end of a resistive/impedance element 206. The resistive/impedance element 206 has a tube-like form with resistance on the outside full circumference thereof. In the example, a tip component 208 is coupled, by way of an electro-mechanical bond, with an end of the resistive/impedance element 206 opposite the end thereof that is coupled with the plunger base 204.

As with the test probe tip 100 illustrated by FIGURE 1, a spring mechanism may be trapped or otherwise positioned within the barrel component 202, and the plunger base 204 may be configured to slide axially inside the barrel component 202 and be acted upon by the spring mechanism therein to advantageously create a compression resistance.

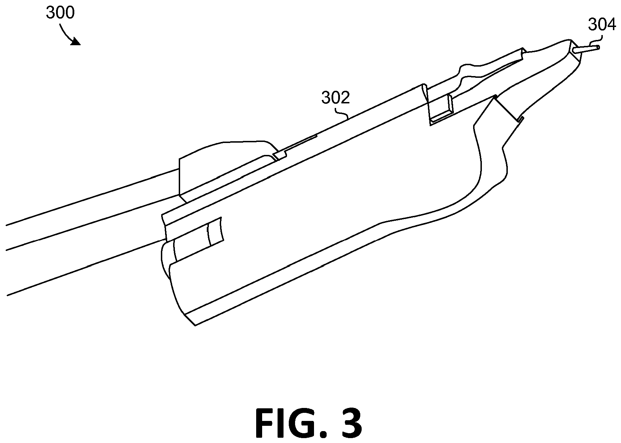

FIGURE 3 illustrates an example of a single-tip test probe 300 in accordance with certain embodiments of the disclosed technology. In the example, the test probe 300 includes a test probe body 302 and a test probe tip 304, such as the test probe tips 100 and 200 illustrated by FIGURES 1 and 2, respectively. A user may use the test probe 300 to create a compression resistance between the test probe tip 304 and a test point, such as a high-speed signal access point or other suitable point on a DUT, for example.

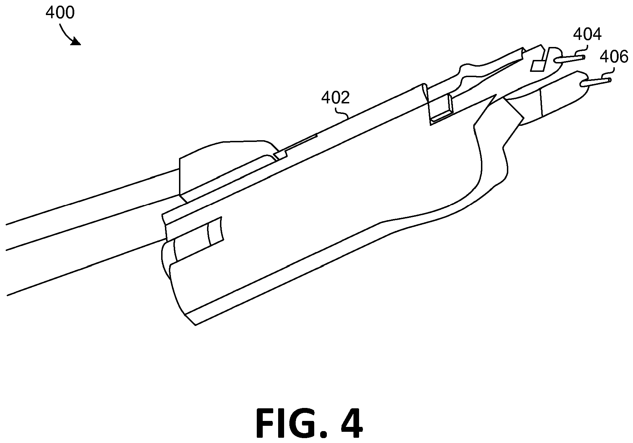

FIGURE 4 illustrates an example of a differential probe 400 in accordance with the claimed invention. In the example, the differential probe 400 includes a probe body 402 and two test probe tips 404 and 406, such as the test probe tips 100 and 200 illustrated by FIGURES 1 and 2, respectively. A user may use the differential probe 400 to create a compression resistance between either or both of the test probe tips 404 and 406 and one or two test points, such as a high-speed signal access point or other suitable point on a DUT, for example.

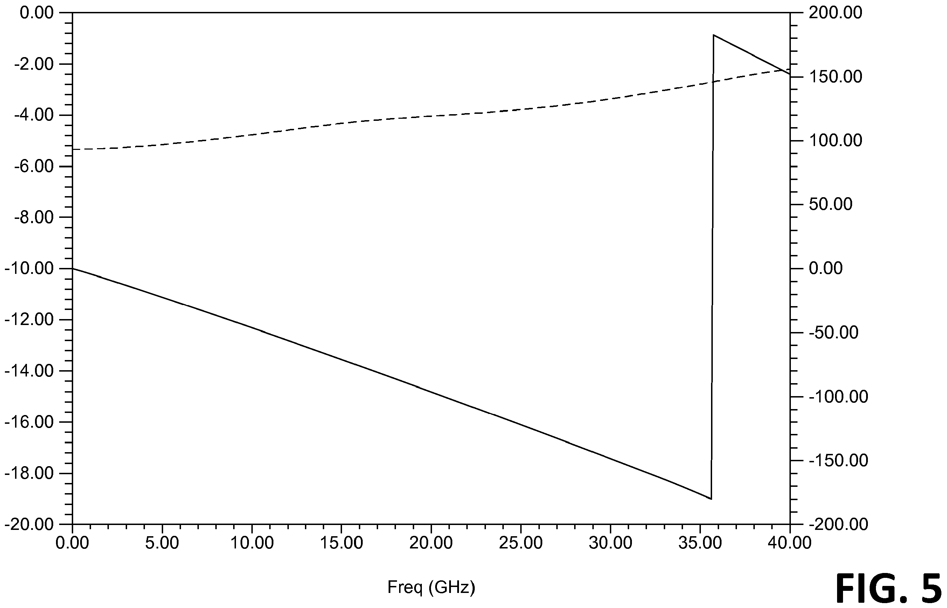

FIGURE 5 is a graphical representation of an example of a frequency response plot 500 for a test probe tip in accordance with certain embodiments of the disclosed technology. The configuration of the resistor fabrication (e.g., rod tube nature) and close proximity to the contact point of the DUT contact generates a highly flat response to signals on the DUT, yielding high signal reproduction fidelity while keeping DUT loading to a minimum. This is important for measuring signal busses that are sensitive to loading. If the tip/probe input structure loads (e.g., reduces or alters the signal eye) the signaling between transmitter-receiver is interrupted, the communication bus under test fails to work properly, which ruins the test. Probe tips in accordance with the disclosed technology advantageously limits this issue greatly.

Examples provide a test probe tip, comprising a force deflecting assembly, a resistive/impedance element configured to be coupled with the force deflecting assembly, wherein the resistive/impedance element is a round rod resistor, and a tip component configured to be coupled with the resistive/impedance element.

In some examples the force deflecting assembly includes a plunger component configured to be coupled with the resistive/impedance element, a barrel component configured to receive the plunger component, wherein the plunger component is configured to slide axially inside the barrel component, and a spring mechanism positioned within the barrel component and configured to act on the plunger component responsive to the plunger component sliding in an inward direction inside the barrel component.

In some examples the resistive/impedance element is coupled with the plunger component by way of an electro-mechanical bond.

According to the invention, the tip component is coupled with the resistive/impedance element by way of an electro-mechanical bond.

In some examples the tip component includes at least one sharp point configured to establish an electrical connection with a test point on a device under test (DUT).

In some examples the spring mechanism is configured to create a compression resistance between the probe tip and a test point on a device under test (DUT).

According to the invention, the round rod resistor includes a resistive coating covering a tube.

According to the invention, the metal connection of the round rod resistor includes a short overlapping tube on each end.

Examples provide a test probe, comprising a test probe body, and at least one test probe tip integrated with the test probe body, each test probe tip including a compliance member, a resistive/impedance element configured to be coupled with the compliance member, wherein the resistive/impedance element is a round rod resistor, and a tip component configured to be coupled with the resistive/impedance element.

In some examples the compliance member includes a plunger component, a barrel component configured to receive the plunger component, wherein the plunger component is configured to slide axially inside the barrel component, and a spring mechanism positioned within the barrel component and configured to act on the plunger component responsive to the plunger component sliding in an inward direction inside the barrel component.

In some examples, the resistive/impedance element is coupled with the plunger component by way of an electro-mechanical bond.

According to the invention, the tip component is coupled with the resistive/impedance element by way of an electro-mechanical bond.

In some examples, the tip component includes at least one sharp point configured to establish an electrical connection between the test probe and a test point on a device under test (DUT).

In some examples, the spring mechanism is configured to create a compression resistance between the test probe and a test point on a device under test (DUT).

According to the invention, the differential probe comprises two test probe tips.

In some examples the compliance member of each of the two test probe tips includes a plunger component, a barrel component configured to receive the plunger component, wherein the plunger component is configured to slide axially inside the barrel component, a spring mechanism positioned within the barrel component and configured to act on the plunger component responsive to the plunger component sliding in an inward direction inside the barrel component.

According to the invention, the round rod resistor includes a resistive coating covering a tube.

According to the invention, the metal connection of the round rod resistor includes a short overlapping tube on each end.

Having described and illustrated the principles of the invention with reference to illustrated embodiments, it will be recognized that the illustrated embodiments may be modified in arrangement and detail without departing from such principles, and may be combined in any desired manner. And although the foregoing discussion has focused on particular embodiments, other configurations are contemplated.

In particular, even though expressions such as "according to an embodiment of the invention" or the like are used herein, these phrases are meant to generally reference embodiment possibilities, and are not intended to limit the invention to particular embodiment configurations. As used herein, these terms may reference the same or different embodiments that are combinable into other embodiments.

Consequently, in view of the wide variety of permutations to the embodiments that are described herein, this detailed description and accompanying material is intended to be illustrative only, and should not be taken as limiting the scope of the invention. What is claimed as the invention, therefore, is all such modifications as may come within the scope of the following claims.

## Claims

1. A differential test probe (300), comprising:
a test probe body (302, 402); and
first and second test probe tips integrated with the test probe body (302, 402), each test probe tip including:
a compliance member;
a round rod resistor (106, 206) including a resistive coating covering a tube and including a first end surface formed by a first overlapping tube on a first end of the round rod resistor (106, 206) and a second end surface formed by a second overlapping tube on a second end of the round rod resistor (106, 206), the round rod resistor (106, 206) coupled with the compliance member; and
a tip component (108, 208), coupled with the round rod resistor (106, 206) via an
electro-mechanical bond formed between the second end surface and an opening formed in the tip component (108, 208) to receive the second overlapping tube, the tip component (108, 208) configured to establish an electrical connection between the test probe (300) and a test point on a communication bus of a device under test (DUT), and
wherein the round rod resistor (106, 206) is exposed when the probe tip is in an assembled state.

2. The test probe (300) of claim 1, wherein the compliance member of each test probe tip includes:
a plunger component coupled with the round rod resistor (106, 206) via an electro-mechanical bond;
a barrel component (102) configured to receive the plunger component, wherein the plunger component is configured to slide axially inside the barrel component (102); and
a spring mechanism positioned within the barrel component (102) and configured to act to apply compression resistance to the tip component (108, 208), via the plunger component responsive to the plunger component sliding in an inward direction inside the barrel component (102).

## Patentansprüche

1. Differentialprüfsonde (300), umfassend:
einen Prüfsondenkörper (302, 402); und
erste und zweite Prüfsondenspitzen, die in den Prüfsondenkörper (302, 402) integriert sind, wobei jede Prüfsondenspitze umfasst: ein Nachgiebigkeitselement;
einen Rundstabwiderstand (106, 206), der eine Widerstandsbeschichtung umfasst, die ein Rohr bedeckt, und eine erste Endfläche, die durch ein erstes überlappendes Rohr an einem ersten Ende des Rundstabwiderstands (106, 206) gebildet wird, und eine zweite Endfläche, die durch ein zweites überlappendes Rohr an einem zweiten Ende des Rundstabwiderstands (106, 206) gebildet wird, umfasst, wobei der Rundstabwiderstand (106, 206) mit dem Nachgiebigkeitselement gekoppelt ist; und eine Spitzenkomponente (108, 208), die mit dem Rundstabwiderstand (106, 206) über eine elektromechanische Verbindung gekoppelt ist, die zwischen der zweiten Endfläche
und einer Öffnung ausgebildet ist, die in der Spitzenkomponente (108, 208) ausgebildet ist, um das zweite überlappende Rohr aufzunehmen, wobei die Spitzenkomponente (108, 208) konfiguriert ist, um eine elektrische Verbindung zwischen der Prüfsonde (300) und einem Prüfpunkt an einem Kommunikationsbus einer zu prüfenden Vorrichtung (DUT) herzustellen, und
wobei der Rundstabwiderstand (106, 206) freigelegt ist, wenn sich die Sondenspitze in einem zusammengebauten Zustand befindet.

2. Prüfsonde (300) nach Anspruch 1, wobei das Nachgiebigkeitselement jeder Prüfsondenspitze umfasst:
eine Kolbenkomponente, die mit dem Rundstabwiderstand (106, 206) über eine elektromechanische Verbindung gekoppelt ist;
eine Zylinderkomponente (102), die konfiguriert ist, um die Kolbenkomponente aufzunehmen, wobei die Kolbenkomponente konfiguriert ist, um axial innerhalb der Zylinderkomponente (102) zu gleiten; und
einen Federmechanismus, der innerhalb der Zylinderkomponente (102) positioniert ist und konfiguriert ist, um einen Kompressionswiderstand auf die Spitzenkomponente (108, 208) über die Kolbenkomponente als Reaktion darauf auszuüben, dass die Kolbenkomponente in einer Einwärtsrichtung in der Zylinderkomponente (102) gleitet.

## Revendications

1. Sonde d'essai différentielle (300), comprenant :
un corps de sonde d'essai (302, 402) ; et
des première et seconde pointes de sonde d'essai intégrées au corps de sonde d'essai (302, 402), chaque pointe de sonde d'essai comprenant :
un élément de conformité ;
une résistance à tige ronde (106, 206) comprenant un revêtement résistif recouvrant un tube et comprenant une première surface d'extrémité formée par un premier tube de chevauchement sur une première extrémité de la résistance à tige ronde (106, 206) et une seconde surface d'extrémité formée par un second tube de chevauchement sur une seconde extrémité de la résistance à tige ronde (106, 206), la résistance à tige ronde (106, 206) étant couplée à l'élément de conformité ; et
un composant de pointe (108, 208), couplé à la résistance à tige ronde (106, 206) via une liaison électromécanique formée entre la seconde surface d'extrémité et une ouverture formée dans le composant de pointe (108, 208) pour recevoir le second tube de chevauchement, le composant de pointe (108, 208) étant configuré pour établir une connexion électrique entre la sonde d'essai (300) et un point d'essai sur un bus de communication d'un dispositif sous test (DUT), et
dans laquelle la résistance à tige ronde (106, 206) est exposée lorsque la pointe de sonde est dans un état assemblé.

2. Sonde d'essai (300) selon la revendication 1, dans laquelle l'élément de conformité de chaque pointe de sonde d'essai comprend :
un composant de piston couplé à la résistance à tige ronde (106, 206) via une liaison électromécanique ;
un composant de cylindre (102) configuré pour recevoir le composant de piston, dans laquelle le composant de piston est configuré pour coulisser axialement à l'intérieur du composant de cylindre (102) ; et
un mécanisme de ressort positionné à l'intérieur du composant de cylindre (102) et configuré pour agir afin d'appliquer une résistance à la compression au composant de pointe (108, 208), via le composant de piston en réponse au coulissement du composant de piston dans une direction vers l'intérieur à l'intérieur du composant de cylindre (102).
